# EUROPEAN PATENT SPECIFICATION

(11) **EP 3 213 381 B1**
(45) Date of publication and mention of the grant of the patent: **16.09.2020**
(21) Application number: 15805554.1
(22) Date of filing: 27.10.2015
(51) Int. Cl.: H02H 3/40, G01R 31/08, H02H 7/28, H02H 1/00

(54) **METHOD AND PROTECTION DEVICE FOR ELIMINATING EARTH FAULTS OF TRANSIENT TYPE IN AN ELECTRIC DISTRIBUTION NETWORK**
VERFAHREN UND SCHUTZVORRICHTUNG ZUR BESEITIGUNG VON ERDFEHLERN VON TRANSIENTEN IN EINEM STROMVERTEILUNGSNETZ
PROCÉDÉ ET DISPOSITIF DE PROTECTION PERMETTANT D'ÉLIMINER DES DÉFAUTS DE TERRE DE TYPE TRANSITOIRE DANS UN RÉSEAU DE DISTRIBUTION ÉLECTRIQUE

(30) Priority: 28.10.2014 FI 20145944
(43) Date of publication of application: 06.09.2017
(73) Proprietor: Arcteq Relays Oy, 65300 Vaasa (FI)
(72) Inventor: VIRTALA, Tero, FI-65370 Vaasa (FI)
(74) Representative: Kespat Oy
(86) International application number: PCT/FI2015/050737
(87) International publication number: WO 2016/066898

(56) References cited:
- EP-A1- 2 741 389
- WO-A1-99/12048
- US-A1- 2013 043 879

## Description

The invention relates to a method, according to the preamble to Claim 1, for protecting an electrical distribution network, and particularly for protecting a medium-voltage network from an intermittent or temporary earth fault.

Many different kinds of earth fault can occur in an electrical distribution network. In buried-cable networks, earth faults are generally permanent and with a low fault resistance. Such faults require the faulty conductor portion to be disconnected from the rest of the network. In an overhead network, arcing earth faults typically appear, which can be eliminated with the aid of reconnections.

A case of a fault differing from the above is an intermittent earth fault, in which the contact with the earth breaks and the duration of the fault is considerably shorter than the duration of a cycle. Such an intermittent transient-type earth fault can be caused, for example, by damage to the insulation of the cable. A branch breaking over an aerial conductor often causes a momentary, but temporary earth fault. In a compensated network, the probability of an earth fault terminating is high, but, if insulation damage has occurred, the fault will probably constantly recur. The fault will then appear as repeated powerful earth-fault current spikes and as corresponding rapid changes in the momentary value of the residual voltage. The precise ignition point is random, due to the general nature of the strike-through phenomenon.

The degree of compensation of the network affects the repetition of a transient fault. In a fully compensated network, the residual voltage damps out for several cycles and the fault can repeat at intervals of a few hundred milliseconds. In an earth-fault situation, the saturation of the Petersen coil creates transient disturbances that are difficult to interpret. Many other of the particular features of the network create the most complex responses to an earth fault. If compensation is aligned to the side, the fault can repeat at intervals of a half cycle, because the residual voltage does not have time to damp between the faults.

In this connection, the term a temporary earth fault refers to an earth fault, in which contact with the earth is of very short duration, so that the earth fault extinguishes rapidly. The current pulse then arising is similar to that in an intermittent earth fault.

An intermittent or temporary earth fault can also appear in a network that is insulated from the earth or earthed through a resistance. Unless an intermittent earth fault is identified selectively, the result can be that an extensive portion of the network is tripped to become dead, for example, the breaker of the input cell of a sub-station being tripped, instead of only the damaged conductor outlet being separated from the network. Such a problem is typically a result of the value of the residual voltage used as a condition of the backup protection remaining large for a time that is clearly longer than the current pulses.

The protective devices generally used for locating directional earth faults, which are based on FFT calculation, are not suitable for detecting transient-type faults.

Finnish patent FI121612B (Vamp) discloses one method used to protect against transient faults, in which, when a current spike occurs, the signals from the measured residual voltage and the measured zero current are processed as samples. The rate of change of the zero current and the simultaneous residual voltage (differentiated residual voltage) are the basis of calculation. A basic-frequency component is damped from them. The product of the processed values is summed as the time of a preselected time counter. If the sum is negative, the branch line is ascertained to be faulty and is separated from the network. The method requires a considerable amount of processing of the sample signals. An advantage of the method is that it does not require a high sampling frequency.

Japanese application publication JP2003164055 (Kansai ..) discloses a method, in which the ratio of the rate of change of the zero current and the simultaneous residual voltage is determined, from the cumulative value of which a conclusion is drawn on a transient earth fault. According to the publication, other arithmetic variables are also formed with the aid of the rate of change of the zero current and the residual voltage, for example, their product.

Publication EP2417467B1 (Alstom) discloses a method for detecting a transient earth fault, in which the direction of the power of the strike-through spike is calculated. The power is calculated from the sampled zero current and the values of the residual voltage by averaging the integrated sum over the cycle. The method uses quite complex matrix operations, such as the Hilbert transform.

The above publications have the following common features,
- the residual voltage and zero current of at least one branch line are measured to give residual-voltage and zero-current signals,
- the measured residual-voltage and zero-current signals are sampled continuously at a selected sampling frequency, and
- the samples obtained are buffered periodically in the residual-voltage buffer memory and the zero-current buffer memory respectively, and
- each recorded cycle is analysed using the buffered data, the registered maximum value of its indices and selected voltage information,
- a transient spike is identified as a fault, candidate, when spikes with different directions are detected according to a selected criterion.

Further methods for earth fault detection are disclosed in the following documents: WO99/12048, US2013/043879 and EP2741389.

The sudden narrow spike in the zero current caused by an earth fault is difficult to detect from a sampled signal, if the sampling frequency is 32 samples/cycle, i.e. 1, 6 kHz. Even at a frequency of 3.2 kHz the signal can be considerably distorted. The spike can be clearly seen at a sampling frequency of 20 kHz (network frequency 50 Hz), but in practical device technology this is much too far.

As such, a method monitoring the polarity of the spike is known, in which the polarities of the zero current and residual voltage of the transient spike caused by a detected intermittent earth fault are opposite. So far, there has not been a simple and reliable algorithm-based application for this method.

False alarms are a problem in all electrical-network control, particularly in the monitoring of transient phenomena. The transient spike caused by a fault causes considerable after-oscillations in the healthy portion of the network. An intermittent, transient-type earth fault can easily be mistaken for a low-resistance continuous earth fault, because power after-oscillations after a sharp spike occur in both. A computational method based on modelling becomes so complex that it is not in practice possible due to the multifariousness of electrical networks and their fault states.

The present invention is intended to create a simpler, particularly reliable method for detecting and eliminating transient-type earth faults, using an algorithm-based solution to identify a faulty branch line. The aim is to detect an intermittent earth fault in all kinds of electrical network and distinguish it from a normal earth fault.

The characteristic features of the method according to the invention are stated in the accompanying Claim 1. According to the invention, the sampling frequency need not be even close to the frequency (20 kHz) purely depicting a zero-current spike, instead, a frequency of 32 samples/cycle, preferably 64 - 128 samples/cycle, will be sufficient, thanks to the developed algorithm. The frequency required is higher than that generally used in protective devices in an electrical network, but nevertheless can be implemented in practice (3.2 kHz in a 50-Hz network). Here, the sampling frequency sufficient for effective and reliable identification does not bring out the transient spike visually, but each spike leaves a trace in the measurement chain that permits identification when the algorithm combines different factors. The characteristic features of a protection device utilizing the method are stated in Claim : 12.

Preferably, the accuracy of the method according to the invention in detecting repeated earth faults is considerably improved by taking, in the calculation of an admittance-delta, the voltage difference from that side of the index defined, in which the voltage difference is greater. The voltage difference is calculated on both sides of the index defining the zero-current maximum, and the larger of these is selected, because it most probably depicts the fault state.

Further, the accuracy of the method in identifying repeated earth faults is considerably improved by always closing identification for a selected delay when parallel I0 and U0 spikes are observed. On the other hand, the certainty of identification improves if it is required that wrong spikes must not come for a selected period of time after the identification of a fault candidate. Typically, a correct alarm and disconnection occur in a faulty branch line at the same time as the monitoring devices in the healthy branch lines detect parallel spikes, which creates a momentary closing time in them to react to other spikes. The method can then be exploited for quite low threshold values for an alarm, without fear of false alarms. The detected zero-current and residual-voltage transient spikes are roughly simultaneous, but always at slightly different times. This is due to the impedance of the network. In a fault state, it is not possible to know the state of the network, instead the detection of a fault must be shown in all circumstances (under compensated / over compensated).

The magnitude of the offset is selected according to the sampling frequency. The offset is preferably on average 1/8 of the length of the cycle, generally in the range -25%...+50 % of this length. If there are 32 samples in the cycle, the offset is selected from the range 3 - 6.

The clearest additional criterion is obtained by requiring a second forward-direction (FWD) spike within a set time (FWDreset) of the detection. After that, addition time (TRIP) can be required for tripping, during which reverse-direction (REV) spikes must not appear. The number of FWD spikes creating an alarm is preferably 2 and the calculation time is 250 ms (generally 100 - 1000 ms). In one embodiment, the detection of the second spike can be replaced with an arrangement monitoring the stability of the residual, voltage. The additional, criterion of a transient fault comprises the monitoring of the stability of the said residual voltage.

Preferably the stability of the residual voltage is also monitored immediately after the spike and the fault is classified as a continuous earth fault according to a preselected criterion. This is because it is difficult to distinguish a continuous earth fault, from an intermittent earth fault. A preferred embodiment compares the last max U0 measurement with the mean of the five previous measurements. If the ratio obtained is in the range 98 - 102 %, the fault is classified immediately after the spike as a continuous earth fault.

In the following, the invention is described in detail with reference to the accompanying drawing showing some embodiments of the invention, in which
- Figure 1: shows the circuit of a transient protection device when monitoring 3-phase four input lines,
- Figure 2a: shows the zero current of a branch line when a transient earth fault appears,
- Figure 2b: shows a corresponding event to that of Figure 2a for the residual voltage,
- Figure 2c: shows an event corresponding to that of Figure 2b, seen in a healthy branch line,
- Figures 3a-3c: show a situation corresponding to that in Figures 2a - 2c, in a non-compensated electrical network,
- Figure 4: shows schematically the internal circuit of one protection device of Figure 1.

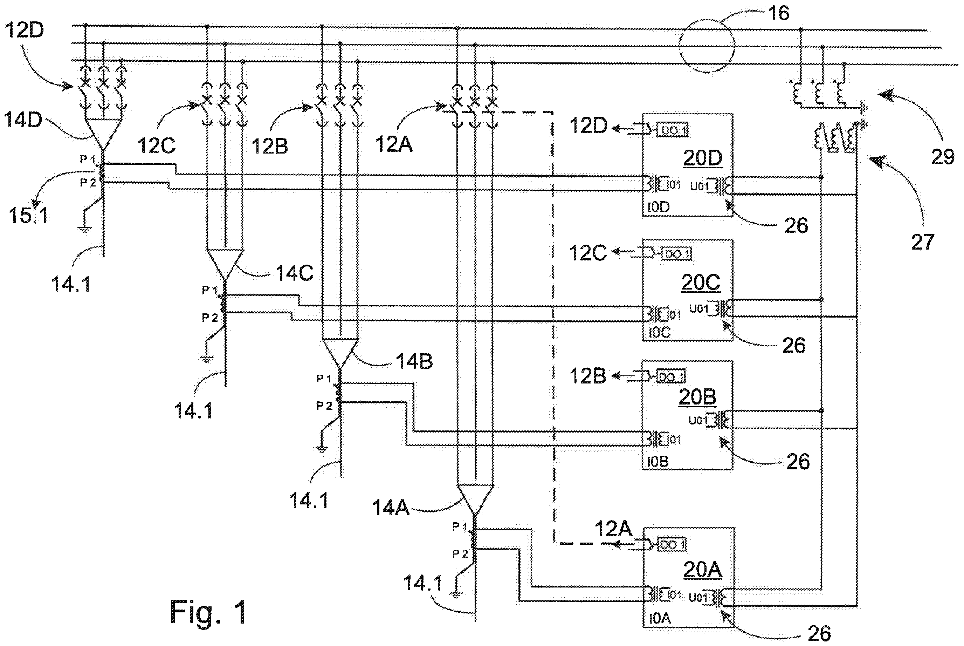

The smart protection devices 20A, 20C, 20C, and 20D of Figure 1 each monitor a branch line (A, B, C, and D) connected to the main line 16. Each protection device comprises an independent microcontroller with processors and memories and I/O means. Each branch line is connected to a cable terminal 14A, 14B, 14C, and 14D. Input is taken to each branch line from the phases L1, L2, L3 of the main line 16. Each branch line is protected by a 3-phase breaker 12A, 12B, 12C, and 12D. Each breaker 12A, 12B, 12C, and 12D is controlled by the said protection device 20A, 20C, 20C, and 20D. In each of these is an input U01 measuring the residual voltage of the main line and a current input I01 measuring the zero current of the branch line. The operating device of each 3-phase breaker 12A, 12B, 12C, and 12D is connected to the outlet D01 of the corresponding operating device, by means of which disconnection is performed if required. In Figure 1, the relay D01 of the protection device 20A is connected to the breaker 12A.

Residual-voltage detection uses a common star-connected primary-coil series 29. The residual voltage to each voltage input U0 is formed by means of the open-delta connection 27 of the potential transformer. Residual voltage is taken to the voltage-measurement transformer 26 of each protection device (or directly to the voltage divider). The current measurements are taken to the input I01 of each current-measurement transformer 24.

Each protection device 20A, 20C, 20C, and 20D breaks its own branch line to become dead when an intermittent earth fault is detected according to the logic disclosed hereinafter. Triggering of the break is reliable already after a period of time set from the second transient earth fault (e.g., 250 ms). Suitable alternative addition criteria can be used.

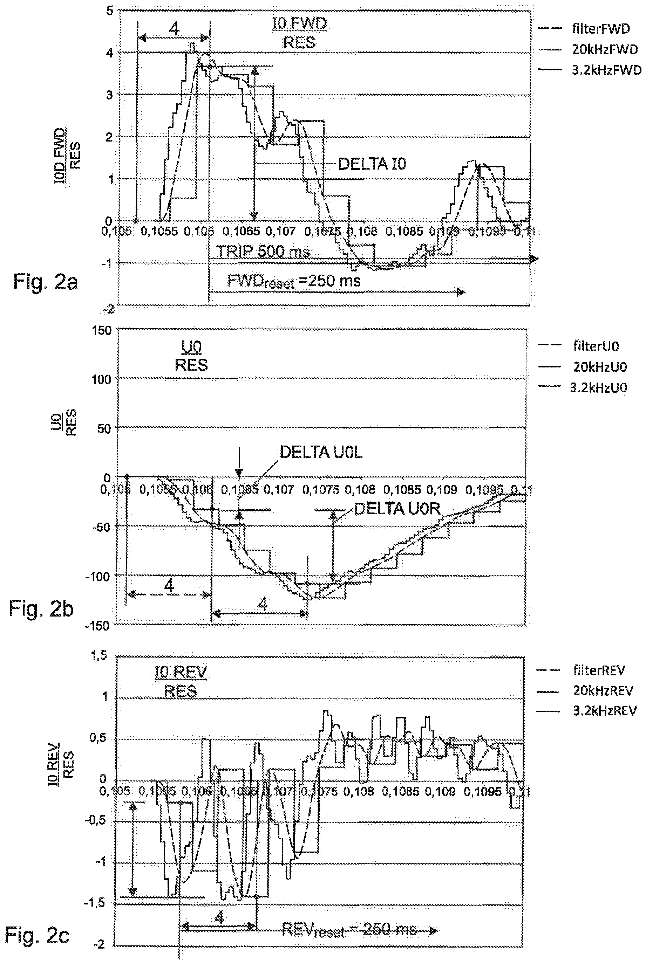

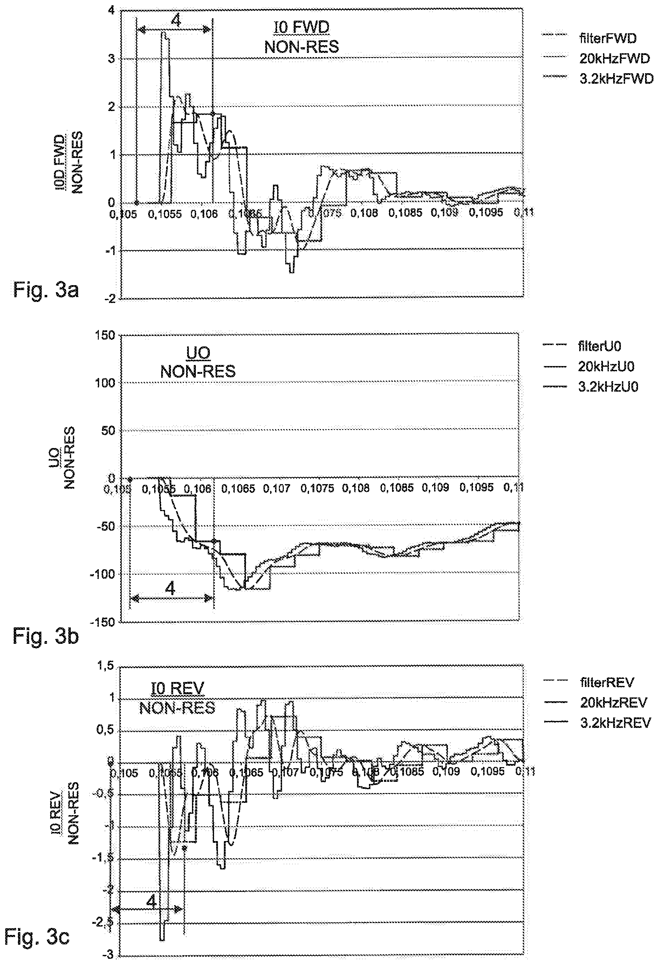

Figures 2a - c and Figures 3a - c show the current and voltage graphs of a transient earth fault from the period of time of the sampling buffers (64 samples). The buffers are updated every 5. ms, when the oldest 16 samples are removed from the buffer memories and a new 16 samples are added to the end (FIFO) .

In the graphs, the thin, unbroken line is the real signal simulated at a frequency of 20 kHz, the line of dots and dashes in the signal sampled at a frequency of 3.2 kHz, and the line of long dashes is the signal filtered from this. It is important that the practical sampling frequency (in this case 64 samples per cycle) 'loses' a considerable degree of the shape of the sharp transient pulse, but nevertheless the algorithm developed is able to perform this identification task very well. The reliability of operation is significantly influenced by the logic of the algorithm when monitoring healthy branch lines, which prevents wrong triggering, for instance, due to oscillation created by the healthy part of the network, or in connection with a directed continuous earth fault.

The zero-current graph showing a real earth fault is marked with the reference I0FWD and the zero-current graph of an undamaged branch line with the reference I0REV. The common residual-voltage graph is marked with the reference U0.

In Figure 2a, the precise location of the maximum value of the I0 signal is retrieved from the buffer, i.e. the index (i) in question from the buffer.

If the location of the maximum value is not right at the edge of the buffer, but somewhere in the middle, calculation is commenced, otherwise there is a wait for the following cycle, when the maximum value will be +16 samples to the middle.

The first start requires both the zero-current maximum and the residual-voltage maximum to exceed the threshold values set for them. This resets rapidly (25 ms) and does not lead to further measures unless calculation finds some error pulses.

The current change DELTAI0 is calculated using the offset value of the selected index (i) (here, offset = 4). This offset value (3 - 6, if the sampling frequency is 64 samples/cycle)) is determined experimentally and depends on the sampling frequency. When the sampling frequency increases, the offset value is increased correspondingly - generally the offset is 1/16 of the length of the cycle -25....+50 %. In practice, the value of I0 can be used directly as the approximate value of DELTAI0, because usually the initial difference is zero.

The maximum point of the zero current I0 in the buffer is explicit. It is the peak of the largest spike. At this stage, the situation of the residual voltage U0 is not as clear, so that the residual-voltage changes DELTAU0R (right) and DELTAU0L (left) are calculated from both sides of the index (i) defined by the zero-current I0 spike in the buffer, Figure 2b. The peak of the zero current 10 and the peak of the residual voltage U0 never occur at the same location in the buffers.

In this example, the right-hand residual-voltage change DELTAUOR is clearly greater is chosen for further calculation as the voltage change DELTAUO, because it represents a change caused by a fault.

Next, the computational admittance-delta INADMIT = DELTAI0/DELTAU0 is calculated.
A negative value indicates a faulty branch line (FWD direction) and a positive value a healthy branch line (REV direction) .

A second level start follows, if the admittance-delta INADMIT exceeds the set threshold value. This admittance start starts the FWD or REV alarm timer, otherwise the spike is forgotten.

A negative admittance-delta, the FWD spike is a fault candidate and starts two time counters: FWD counter (FWDreset = 250 ms) to collect FWD spikes and a trip counter 500 ms to make the final tripping.

A positive admittance-delta (FWD) starts the REV counter (counter 3), REVreset = 250 ms. This resets the above counters and closes the starts, until its time is complete.

If, during the FWDreset time, at least one, i.e. a second, FWD spike occurs, or several FWD spikes occur, it means an intermittent earth fault, which leads to an alarm, unless REV spikes come during the time of the tripping counter.

The direction of the fault tells directly the polarity of the admittance-delta INADMIT. If the admittance-delta INADMIT is negative, a real fault (FWD) has been detected in the branch line in question. If it is positive, the detection of the fault (REV) (Figure 2c) is in an undamaged branch, i.e the oscillation in a healthy network created by an actual fault, or some other disturbance. In the case of Figure 2c, the voltage difference is calculated in the same way as above, using here the index (i) of the maximum point of the zero-current 10 buffer to determine the residual-voltage difference from the graph of Figure 2b, in such a way that the larger voltage difference from beside the index is taken for further calculation.

If new FWD spikes are not detected and the alarm timer concludes counting, i.e. reaches 250 ms, the starts are reset. If a REV spike is detected during the cycle, the FWD counter is reset and the REV time counter is set, during which time no reaction takes place to FWD spikes. A new REV spike starts the closing-time counter from the beginning.

Once the FWD time counter's 250 ms is full, a move is made to the next stage, i.e. to the possible issuing of a command to disconnect. If at least two FWD spikes have come during the cycle and the counter (TRIP) has reached the end, disconnection follows 500 ms after the counter's time is full, unless REV spikes come before tripping.

It is of course obvious that, at the moment of recording the signals according to Figures 2a and 2c it is not known to which class (FWD or REV) the situation recorded in each buffer memory belongs. Or the maximum values of the buffer's samples do not exceed the selected threshold values, so that it is not a case of either of them.

Figures 3a-3c show the situation in an under-compensated network, when the identification of a transient earth fault is much more challenging, due to the powerful after-oscillation. The algorithm developed can perform this. It is easy to see from the signal of Figure 3c that there is reason to start a closing time from a REV detection, because otherwise the threshold value can be exceeded even several times, leading to starts due to the same original fault.

In the accompanying examples, measurement of the stability of the residual voltage is not shown immediately after the spike, as a continuous earth fault can be best identified from it, the identification of which can be easily mistaken for an intermittent earth fault.

According to a preselected criterion, the fault is classified as a continuous earth fault, if the residual voltage remains considerably stable after the spike.

It is preferable to compare the latest max U0 measurement to the mean value of a few, for example five, older measurements. If the latest residual voltage U0 is in a set range, for example, in the range 98 - 102 % of the U0 mean value, the fault is classified as a continuous earth fault immediately after the spike and all other starts are closed.

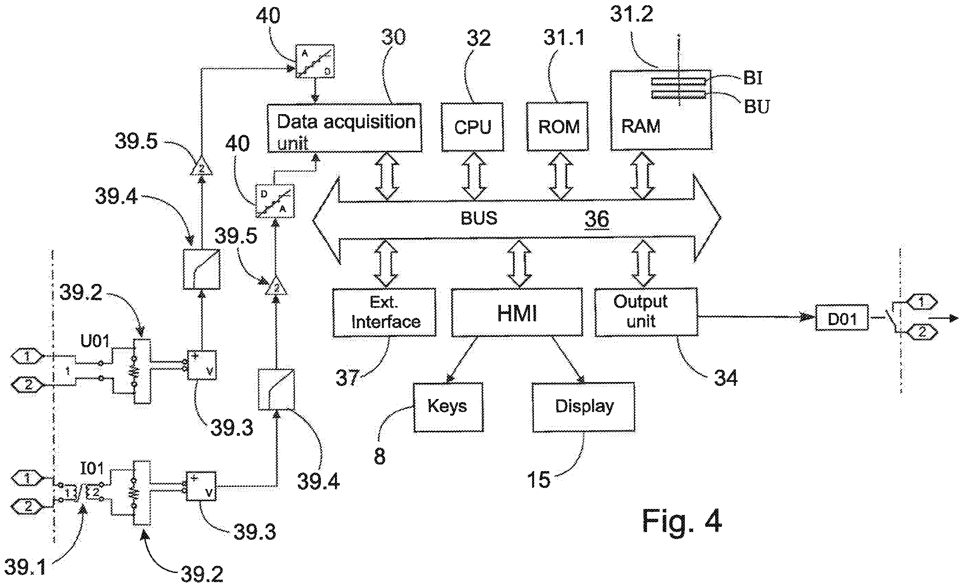

Figure 4 shows a block diagram of a protection device, comprising the analog parts of the current and voltage inputs (101, U01) as far as the A/D converter 40. The analog portion comprises the following components, a current transformer 39.1 (only current input), a shunt resistance 39.2, voltage-divider resistances 39.3, an analog filter 39.4, an amplifier 39.5, and finally the actual A/D converter 40.

The microcontroller is, as such, a conventional computer with application means, comprising the parts:
Data-acquisition unit 30; CPU 32; memories ROM 31.1 and RAM 31.2; bus 36; PC interface 37; HMI (Human-machine interface) 33; output unit 34; relay D01; keys 38, and display 22. The zero-current buffer memory BI and the residual-voltage buffer memory BU are formed programmatically in the RAM memory 31.2 and operate in FIFO mode, i.e. the oldest data is removed at the same time as new data is entered.

The aforementioned functionality is programmed in an application program. The performance of the microcontroller determines how high a sampling frequency can be used.

## Claims

1. Method for identifying transient-type earth faults in a electrical network and selectively tripping the faulty portion, in which electrical network there are several branch lines (A - D) connected to a main line, and in which
• the residual voltage U0 and the zero current 10 of at least one branch line (A-D) are measured to create zero-current and residual voltage signals,
• the measured zero-current and residual-voltage signals are sampled continuously at a selected sampling frequency, and
• the samples obtained are buffered periodically in a zero-current buffer memory (BI) and a residual-voltage buffer memory (BU), respectively,
• each recorded cycle is analysed using the buffered data,
• a transient spike is identified as a fault candidate, if current and voltage spikes in different directions are observed according to a selected criterion,
**characterized in that**, in the method
• each absolute maximum value (I0max) is retrieved from the samples of the zero-current buffer memory (BI) as a current spike and its index (i) in this buffer memory,
• the selected voltage data is retrieved from the residual-voltage buffer memory (BU) using the value of the index (i),
• a value depicting the admittance-delta (INADMIT) is calculated as follows for the transient spike:
• the differences are formed from the samples of the zero-current buffer memory (BI) and the samples of the residual-voltage buffer memory (BU) using the said index (i) and its chosen offset value (i - 4 ; i + 4),
i) wherein the zero current's 10 difference DELTAI0 is calculated from the samples of the zero-current buffer memory (BI) and the residual voltage's U0 difference DELTAUO is calculated from the samples of the residual-voltage buffer memory (BU), and
ii) the admittance-delta INADMIT is calculated as the ratio DELTAI0/DELTAU0,
• the polarity of the admittance-delta (INADMIT) of each spike is determined, with the aid of which each spike is classified as a forward-direction (FWD) or reverse-direction (REV) spike using selected criteria, and
• the fault candidate is ascertained to be a branch-line (A-D) transient earth fault when a forward (FWD) spike is detected in the branch line and a selected additional criterion it met, which criterion is related with detection of a second spike or related with the stability of the residual voltage, within selected time (FWDreset) from the detection of said forward (FWD) spike, and a selective tripping is performed.

2. Method according to Claim 1, **characterized in that** in the calculation of the admittance-delta (INADMIT) the difference of the residual voltage U0 of both sides of the zero current 10 is calculated, creating residual-voltage changes DELTAUOR (right) and DELTAUOL (left), and the larger of them is selected for the said admittance-delta calculation DELTAI0/DELTAU0.

3. Method according to Claim 1 or 2, **characterized in that** the said additional criterion comprises the detection of at least a second forwards (FWD) spike within the set time (FWDreset).

4. Method according to any of Claims 1 - 3, **characterized in that** calculation is commenced only if the absolute values of the sampling buffers zero current 10 and residual voltage U0 exceed the selected threshold values.

5. Method according to any of Claims 1 - 4, **characterized in that** always when a reverse (REV) spike is detected, the detection of forward (FWD) spikes is interrupted for a preselected closing time (REVreset).

6. Method according to any of Claims 1 - 5, **characterized in that** the stability of the residual voltage is also monitored immediately after a spike, when the damping residual voltage creates an interpretation of a transient earth fault and an undamped residual voltage creates an interpretation of a continuous earth fault.

7. Method according to Claim 6, **characterized in that** the said additional criterion comprises a requirement that the residual voltage should damp within a selected time limit.

8. Method according to any of Claims 1 - 6, **characterized in that** the said offset value is in the range 1/16 of the length of the cycle -25....+50 %.

9. Method according to Claims 1 - 8, **characterized in that** the residual voltage (U0) and the zero current (I0) are measured at a sampling frequency of at least 32 samples/cycle, preferably at a frequency of 64 - 128 samples/cycle.

10. Method according to Claims 1 - 9, **characterized in** the zero-current and residual-voltage buffer memories (BI, BU) are updated using the FIFO principle.

11. Method according to any of Claims 1 - 7, **characterized in that** the tripping procedure takes place as the most important stages:
• the spikes larger that a preselected threshold value from the sample data are identified and the data after the spikes is removed,
• the polarities of simultaneous current and voltage spikes are compared,
• the branch line is classified as healthy if the polarities are the same (REV) and faulty if the polarities are opposite (FWD),
• if the polarities are the (REV spike), the REV starting counter is activated for the duration of a preset cycle (REVreset), always restarting the counter in a REV spike reappears,
• if the polarities have different signs (FWD spike), the FWD counter is activated for a selected time, and
• the FWD counter is closed, if a REV spike is identified, and
• tripping of the branch line is initiated, if a number of consecutive FWD spikes according to a preset criterion are identified within a set time (FWDreset) without activating the REV counter.

12. Protection device for monitoring a branch line in an electrical network, **characterized in that** it comprises a microcontroller's CPU (32), memory means (31.1, 31.2), and I/0 means (30) for measuring a zero current and a residual voltage, comprising a signal analog processing part(39.1 - 39.5), A/D converters (40) for sampling signals, and the protection device includes software for implementing a method according to any of Claims 1 - 11.

## Patentansprüche

1. Verfahren zur Identifikation von transientenartigen Erdfehlern in einem elektrischen Netz und selektivem Ausschalten des fehlerhaften Abschnitts, wobei in dem elektrischen Netz mehrere Abzweigleitungen (A - D) mit einer Hauptleitung verbunden sind und
• die Restspannung U0 und der Nullstrom I0 von mindestens einer Abzweigleitung (A-D) gemessen werden, um Nullstrom- und Restspannungssignale zu erzeugen,
• die gemessenen Nullstrom- und Restspannungssignale kontinuierlich auf einer ausgewählten Abtastfrequenz abgetastet werden und
• die erhaltenen Proben regelmäßig jeweils in einem Nullstrompufferspeicher (BI) und einem Restspannungspufferspeicher (BU) gepuffert werden,
• jeder aufgezeichnete Zyklus mit Hilfe der gepufferten Daten analysiert wird,
• eine transiente Spitze als Fehlerkandidat identifiziert wird, wenn Strom- und Spannungsspitzen in unterschiedlichen Richtungen nach einem ausgewählten Kriterium beobachtet werden,
**dadurch gekennzeichnet, dass** in dem Verfahren
• jeder absolute Maximalwert (I0max) aus den Proben des Nullstrompufferspeichers (BI) als eine Stromspitze und sein Index (i) in diesem Pufferspeicher gewonnen wird,
• die ausgewählten Spannungsdaten aus dem Restspannungspufferspeicher (BU) mit Hilfe des Werts des Index (i) gewonnen werden,
• ein Wert, der das Leitwertdreieck (INADMIT) abbildet, für die transiente Spitze wie folgt berechnet wird:
• die Differenzen aus den Proben des Nullstrompufferspeichers (BI) und den Proben des Restspannungspufferspeichers (BU) mit Hilfe des besagten Index (i) und seinem gewählten Versatzwert (i - 4 ; i + 4) gebildet werden,
i) worin die Differenz DELTAI0 des Nullstroms I0 aus den Proben des Nullstrompufferspeichers (BI) und die Differenz DELTAUO der Restspannung U0 aus den Proben des Restspannungspufferspeichers (BU) berechnet werden und
ii) das Leitwertdreieck INADMIT als Verhältnis DELTAI0/DELTAU0 berechnet wird,
• die Polarität des Leitwertdreiecks (INADMIT) jeder Spitze bestimmt wird, mit deren Hilfe jede Spitze als eine vorwärts gerichtete (FWD) oder rückwärtsgerichtete (REV) Spitze mit Hilfe ausgewählter Kriterien klassifiziert wird und
• der Fehlerkandidat als transienter Erdfehler einer Abzweigleitung (A-D) ermittelt wird, wenn eine vorwärtsgerichtete Spitze (FWD) in der Abzweigleitung festgestellt wird und ein ausgewähltes weiteres Kriterium zutrifft, das in Verbindung mit der Feststellung einer zweiten Spitze oder in Verbindung mit der Stabilität der Restspannung steht, innerhalb einer ausgewählten Zeit (FWDreset) nach Feststellung besagter vorwärtsgerichteter (FWD) Spitze, und eine selektive Abschaltung durchgeführt wird.

2. Verfahren nach Anspruch 1, **dadurch gekennzeichnet, dass** bei der Berechnung des Leitwertdreiecks (INADMIT) die Differenz der Restspannung U0 von beiden Seiten des Nullstroms I0 berechnet wird, wodurch Restspannungsänderungen DELTAUOR (rechts) und DELTAUOL (links) erzeugt werden und die größere davon für die genannte Berechnung des Leitwertdreiecks DELTAI0/DELTAU0 ausgewählt wird.

3. Verfahren nach den Ansprüchen 1 oder 2, **dadurch gekennzeichnet, dass** das genannte zusätzliche Kriterium die Feststellung mindestens einer zweiten vorwärtsgerichteten (FWD) Spitze innerhalb der festgelegten Zeit (FWDreset) umfasst.

4. Verfahren nach einem der Ansprüche 1 - 3, **dadurch gekennzeichnet, dass** die Berechnung nur gestartet wird, wenn die absoluten Werte von Abtastpuffer-Nullstrom I0 und -Restspannung U0 die ausgewählten Grenzwerte überschreiten.

5. Verfahren nach einem der Ansprüche 1 - 4, **dadurch gekennzeichnet, dass** immer wenn eine rückwärtsgerichtete (REV) Spitze festgestellt wird, die Feststellung von vorwärtsgerichteten (FWD) Spitzen für eine vorausgewählte Sperrzeit (REVreset) unterbrochen wird.

6. Verfahren nach einem der Ansprüche 1 - 5, **dadurch gekennzeichnet, dass** die Stabilität der Restspannung ebenso unmittelbar nach einer Spitze beobachtet wird, wenn die Dämpfungs-Restspannung eine Interpretation eines transienten Erdfehlers erzeugt und eine ungedämpfte Restspannung eine Interpretation eines kontinuierlichen Erdfehlers erzeugt.

7. Verfahren nach Anspruch 6, **dadurch gekennzeichnet, dass** das genannte zusätzliche Kriterium die Bedingung umfasst, dass die Restspannung innerhalb einer ausgewählten Frist gedämpft werden sollte.

8. Verfahren nach einem der Ansprüche 1 - 6, **dadurch gekennzeichnet, dass** der genannte Versatzwert innerhalb einer Bandbreite von 1/16 der Länge des Zyklus -25....+50 % liegt.

9. Verfahren nach den Ansprüchen 1 - 8, **dadurch gekennzeichnet, dass** die Restspannung (U0) und der Nullstrom (I0) bei einer Abtastfrequenz von mindestens 32 Proben/Zyklus gemessen werden, vorzugsweise bei einer Frequenz von 64 - 128 Proben/Zyklus.

10. Verfahren nach den Ansprüchen 1 - 9, **dadurch gekennzeichnet, dass** die Nullstrom- und Restspannungspufferspeicher (BI, BU) mit Hilfe des FIFO-Prinzips aktualisiert werden.

11. Verfahren nach einem der Ansprüche 1 - 7, **dadurch gekennzeichnet, dass** das Abschaltverfahren als wichtigste Stufe stattfindet:
• die Spitzen über einem vorgewählten Grenzwert von den Probendaten werden festgestellt und die Daten nach den Spitzen entfernt,
• die Polaritäten von gleichzeitigen Strom- und Spannungsspitzen werden verglichen,
• die Abzweigleitung wird als gesund klassifiziert, wenn die Polaritäten dieselben sind (REV) und als fehlerhaft, wenn die Polaritäten entgegengesetzt sind (FWD),
• wenn die Polaritäten dieselben sind (REV-Spitze), wird der REV-Startzähler für die Dauer eines voreingestellte Zyklus (REVreset) aktiviert, wobei der Zähler immer neu gestartet wird, wenn die REV-Spitze wieder auftritt,
• wenn die Polaritäten unterschiedliche Vorzeichen haben (FWD-Spitze), wird der FWD-Zähler für eine ausgewählte Zeit aktiviert und
• der FWD-Zähler wird geschlossen, wenn eine REV-Spitze identifiziert wird und
• die Abschaltung der Abzweigleitung wird initiiert, wenn eine Anzahl von aufeinanderfolgenden FWD-Spitzen nach einem voreingestellten Kriterium innerhalb einer festgelegten Zeit (FWDreset) identifiziert wird ohne Aktivierung des REV-Zählers.

12. Schutzeinrichtung zur Überwachung einer Abzweigleitung in einem elektrischen Netz, **dadurch gekennzeichnet, dass** sie eine Mikrokontroller-CPU (32), Speichermittel (31.1, 31.2) und E/A-Mittel (30) zur Messung eines Nullstroms und einer Restspannung umfasst, mit einem analogen Signalverarbeitungsteil (39.1 -39.5) und A/D-Wandlern (40) für Abtastsignale, und dass die Schutzeinrichtung Software für die Umsetzung eines Verfahrens nach den Ansprüchen 1 - 11 umfasst.

## Revendications

1. Procédé d'identification des défauts de terre de type transitoire dans un réseau électrique et de déclenchement de façon sélective de la partie défectueuse, le réseau électrique contenant plusieurs lignes secondaires (A - D) raccordées à une ligne principale, et dans lequel
• la tension résiduelle U0 et le courant nul I0 d'au moins une ligne secondaire (A-D) sont mesurés pour créer des signaux de courant nul et de tension résiduelle,
• les signaux mesurés de courant nul et de tension résiduelle sont échantillonnés en continu selon une fréquence d'échantillonnage déterminée, et
• les échantillons obtenus sont chargés périodiquement dans une mémoire tampon à courant nul (BI) et une mémoire tampon à tension résiduelle (BU), respectivement,
• chaque cycle enregistré est analysé en utilisant les données mises en mémoire tampon,
• un pic transitoire est identifié comme un candidat défectueux, si des pics de courant et de tension dans différentes directions sont observés selon un critère choisi,
**caractérisé en ce que**, dans ce procédé,
• chaque valeur maximale absolue (I0max) est extraite des échantillons de la mémoire tampon à courant nul (BI) sous la forme d'un pic de courant et de son indice (i) dans cette mémoire tampon,
• les données de tension sélectionnées sont extraites de la mémoire tampon à tension résiduelle (BU) en utilisant la valeur de l'indice (i),
• une valeur représentant le delta d'entrée (INADMIT) est calculée comme suit pour le pic transitoire:
• les différences sont formées à partir des échantillons de la mémoire tampon à courant nul (BI) et des échantillons de la mémoire tampon à tension résiduelle (BU) en utilisant ledit indice (i) et sa valeur de décalage choisie (i - 4 ; i + 4),
i) où la différence I0 du courant nul DELTAI0 est calculée à partir des échantillons de la mémoire tampon à courant nul (BI) et la différence U0 de la tension résiduelle DELTAUO est calculée à partir des échantillons de la mémoire tampon à tension résiduelle (BU), et
ii) le delta d'entrée INADMIT est calculé comme le rapport DELTAI0/DELTAU0,
• la polarité du delta d'entrée (INADMIT) de chaque pic est déterminée, celle-ci permet de classer chaque pic comme un pic à sens direct (FWD) ou à sens inverse (REV) selon des critères choisis, et
• il est établi que le candidat défectueux est un défaut de terre transitoire de ligne secondaire (A-D) lorsqu'un pic à sens direct (FWD) est détecté dans la ligne secondaire et qu'un critère supplémentaire sélectionné est rempli, lequel critère est lié à la détection d'un deuxième pic ou à la stabilité de la tension résiduelle, dans un temps sélectionné (FWDreset) à partir de la détection dudit pic à sens direct (FWD), et un déclenchement sélectif est effectué.

2. Procédé conformément à la revendication 1, **caractérisé en ce que** dans le calcul du delta d'entrée (INADMIT), la différence de la tension résiduelle U0 des deux côtés du courant nul I0 est calculée, créant des variations de tension résiduelle DELTAU0R (à droite) et DELTAU0L (à gauche), et la plus grande d'entre elles est sélectionnée pour ledit calcul du delta d'entrée DELTAI0/DELTAU0.

3. Procédé conformément à la revendication 1 ou 2, **caractérisé en ce que** ledit critère supplémentaire comprend la détection d'au moins un second pic à sens direct (FWD) dans le délai fixé (FWDreset).

4. Procédé conformément à l'une des revendications 1 à 3, **caractérisé en ce que** le calcul n'est lancé que si les valeurs absolues du courant nul I0 et de la tension résiduelle U0 des tampons d'échantillonnage dépassent les valeurs de seuil sélectionnées.

5. Procédé conformément à l'une des revendications 1 à 4, **caractérisé en ce que** toujours lorsqu'un pic à sens inverse (REV) est détecté, la détection des pics à sens direct (FWD) est interrompue pendant un temps de fermeture présélectionné (REVreset).

6. Procédé conformément à l'une des revendications 1 à 5, **caractérisé en ce que** la stabilité de la tension résiduelle est également surveillée immédiatement après un pic, lorsque la tension résiduelle amortie crée une interprétation d'un défaut de terre transitoire et qu'une tension résiduelle non amortie crée une interprétation d'un défaut de terre continu.

7. Procédé conformément à la revendication 6, **caractérisé en ce que** ledit critère supplémentaire comprend une exigence selon laquelle la tension résiduelle doit s'amortir dans une limite de temps sélectionnée.

8. Procédé conformément à l'une des revendications 1 à 6, **caractérisé en ce que** ladite valeur de décalage se situe dans la plage 1/16 de la longueur du cycle -25....+50 %.

9. Procédé conformément à l'une des revendications 1 à 8, **caractérisé en ce que** la tension résiduelle (U0) et le courant nul (I0) sont mesurés à une fréquence d'échantillonnage d'au moins 32 échantillons/cycle, de préférence à une fréquence de 64 à 128 échantillons/cycle.

10. Procédé conformément à l'une des revendications 1 à 9, **caractérisé en ce que** les mémoires tampons à courant nul et à tension résiduelle (BI, BU) sont mises à jour selon le principe FIFO.

11. Procédé conformément à l'une des revendications 1 à 7, **caractérisé en ce que** la procédure de déclenchement se déroule comme les étapes les plus importantes :
• les pics plus importants qu'une valeur seuil présélectionnée des données de l'échantillon sont identifiés, et les données après les pics sont supprimées,
• les polarités des pics de courant et de tension simultanés sont comparées,
• la ligne secondaire est classée comme saine si les polarités sont identiques (REV) et défectueuse si les polarités sont opposées (FWD),
• si les polarités correspondent à (pic REV), le compteur de démarrage REV est activé pour la durée d'un cycle prédéfini (REVreset), toujours en redémarrant le compteur quand un pic REV réapparaît,
• si les polarités ont des signes différents (pic FWD), le compteur FWD est activé pendant un temps sélectionné, et
• le compteur FWD est fermé, si un pic REV est identifié, et
• le déclenchement de la ligne secondaire est lancé, si un certain nombre de pics FWD consécutifs selon un critère prédéfini sont identifiés dans un délai fixé (FWDreset) sans activer le compteur REV.

12. Dispositif de protection pour surveiller une ligne de dérivation dans un réseau de distribution électrique, **caractérisé en ce qu'**il comprend une unité centrale de traitement de microcontrôleur (32), des moyens de mémoire (31.1, 31.2) et des moyens d'entrée/sortie (30) pour mesurer un courant nul et une tension résiduelle, comprenant une partie de traitement analogique de signaux (39.1 - 39.5), des convertisseurs A/N (40) pour échantillonner des signaux, et le dispositif de protection comprend un logiciel pour mettre en œuvre un procédé conformément à l'une des revendications 1 à 11.
